Europäisches Patentamt

(19) European Patent Office

Office européen des brevets

(11) Numéro de publication : **0 204 618 B1**

(12) **FASCICULE DE BREVET EUROPEEN**

(45) Date de publication du fascicule du brevet :
30.01.91 Bulletin 91/05

(51) Int. Cl.⁵ : **H03K 17/14, H03K 17/60**

(21) Numéro de dépôt : **86401133.3**

(22) Date de dépôt : **28.05.86**

(54) **Relais électronique statique autorisant ou établissant un courant de sens quelconque ou un courant alternatif dans un circuit d'utilisation.**

(30) Priorité : **31.05.85 FR 8508228**

(43) Date de publication de la demande :
**10.12.86 Bulletin 86/50**

(45) Mention de la délivrance du brevet :
**30.01.91 Bulletin 91/05**

(84) Etats contractants désignés :
**CH DE GB LI NL**

(56) Documents cités :
**DE-A- 1 905 560
DE-A- 3 120 529
FR-A- 1 274 528
FR-A- 2 069 107
FR-A- 2 418 577
GB-A- 1 124 010
US-A- 3 233 125
US-A- 3 731 004
US-A- 4 093 874
US-A- 4 337 494
US-A- 4 491 744
Nührmann, "Professionelle
Schaltungstechnik", Teil 2,
Stromversorgungsschaltungen, Triac- und
Zündschaltungen", Franzis-Verlag München,
1984, pages 182-189.**

(73) Titulaire : **COMMISSARIAT A L'ENERGIE
ATOMIQUE Etablissement de Caractère
Scientifique Technique et Industriel
31/33, rue de la Fédération
F-75015 Paris (FR)**

(72) Inventeur : **Bohner, Gérard
3, rue du Parc
F-92190 Meudon (FR)**
Inventeur : **Nakach, Alain
16, rue de Frileuse Gometz La Ville
F-91400 Orsay (FR)**
Inventeur : **Sole, Jean
9, rue de Crillon
F-92210 Saint Cloud (FR)**
Inventeur : **Starzynski, Pierre
26, Avenue Roux
F-77140 Nemours (FR)**

(74) Mandataire : **Mongrédien, André et al
c/o BREVATOME 25, rue de Ponthieu
F-75008 Paris (FR)**

## Description

La présente invention concerne un relais autorisant ou interrompant la circulation d'un courant dans un circuit d'utilisation. Elle concerne aussi l'application de ce relais à un circuit d'utilisation dans lequel circule un courant de sens quelconque, ou un courant alternatif.

On connait actuellement deux types de relais : les relais de type électromécanique et les relais électroniques statiques.

Les relais de type électromécanique sont constitués par un électroaimant de commande dont l'armature mobile commande la fermeture ou l'ouverture de contacts.

Ces relais sont essentiellement définis par :
– leur pouvoir de coupure, c'est-à-dire le courant d'utilisation maximum I et la tension d'utilisation maximum V ;
– leur grandeur de commande : tension v ou courant i continu ou alternatif, circulant dans l'électroaimant de commande ;
– leur tension d'isolement entre le circuit d'utilisation et le circuit de commande de l'électroaimant.

L'avantage essentiel de ces relais est qu'ils peuvent être intercalés n'importe où dans un circuit électrique préexistant, à condition que leurs caractéristiques limites V, I, v, i, ainsi que la tension d'isolement ne soient pas dépassées. Ils permettent en outre de séparer le courant de commande et le courant d'utilisation ; ils sont simples et peu coûteux.

Ils ont cependant des inconvénients difficiles à surmonter : ils sont lents (à cause de leur inertie mécanique), leur temps de commutation étant généralement voisin de plusieurs dizaines de millisecondes pour les relais de puissance. Ils produisent des étincelles de rupture qui usent rapidement les contacts qui peuvent également se corroder. Il en résulte que les constructeurs ne garantissent les relais qu'ils fabriquent, que pour un nombre limité de commutations, dans des conditions bien déterminées de fonctionnement. Ils sont bruyants, générateurs de vibrations, sensibles aux chocs et consomment une certaine puissance électrique, même si le courant d'utilisation est nul.

La plupart des relais électroniques statiques connus ne sont pas disponibles sous forme de composants indépendants pouvant être inclus dans un circuit d'utilisation quelconque. Généralement, ces relais statiques sont des circuits particuliers inclus dans un ensemble électronique, possédant la fonction de relais et utilisés en même temps que les autres éléments de cet ensemble. Il n'existe pratiquement pas de relais utilisant des composants statiques, possédant certaines des caractéristiques avantageuses des relais électromécaniques pour pouvoir être substitué à un relais électromécanique entre deux points quelconques d'un ensemble électronique préexistant, sans entraîner de modification de cet ensemble.

En effet, la réalisation d'un relais statique électronique nécessite d'alimenter ses composants ; ceci soulève des difficultés importantes si la tension à commuter est flottante par rapport à une masse de référence. Ces relais statiques connus posent également des problèmes d'isolement et de courant de fuite entre le circuit d'utilisation et le circuit de commande; de plus, ils fonctionnent très mal au voisinage d'un courant d'utilisation nul. Ils ne peuvent être commutés à une fréquence très élevée.

Il est apparu depuis peu un relais statique électronique indépendant, à couplage photoélectrique, mais ce relais présente un domaine d'emploi précis et ne fonctionne pas jusqu'à un courant, ou une tension nuls.

Les relais statiques connus, qui présentent ces inconvénients peuvent comprendre soit des thyristors, soit des transistors.

Le relais statique à thyristor utilise un circuit d'alimentation isolé et ne fonctionne pas correctement dès que le courant d'utilisation qui traverse le thyristor est inférieur au dixième de la valeur nominale de ce courant.

Le relais statique à transistor utilise aussi une alimentation isolée si l'on souhaite introduire ce relais entre deux points quelconques d'un circuit d'utilisation.

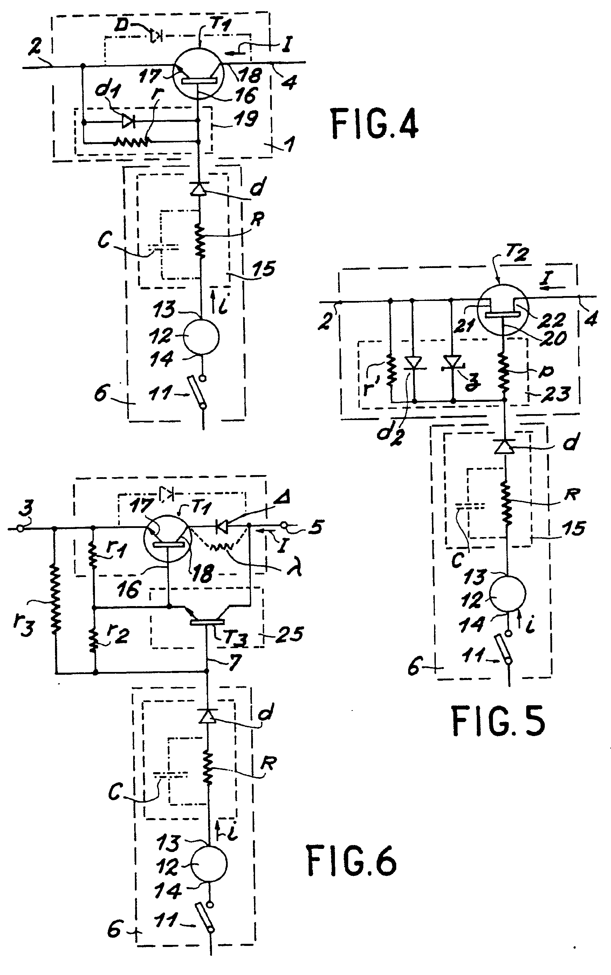

Des relais connus et qui présentent les inconvénients mentionnés plus haut sont décrits par exemple dans les documents suivants :
– Dieter Nührmann, "Professionelle Schaltungstechnik", Teil 2, "Stromversorgungsschaltungen, Triac- und Zündschaltungen", Franzis-Verlag München, 1984, pages 182-189 dans lequel la figure 6.20-1 montre un relais selon le préambule de la revendication 1,
– GB-A-1 124 010,
– FR-A-2 069 107,
– US-A-3 731 004.

La présente invention a pour but de remédier aux inconvénients des relais électromécaniques et aux inconvénients des relais électroniques statiques utilisant des thyristors ou des transistors. Elle a notamment pour but de réaliser un relais statique qui ne possède aucune pièce mobile et qui ne produit aucune étincelle de rupture dans un circuit d'utilisation. Elle a aussi pour but d'obtenir un relais flottant ne nécessitant pas de fixer le potentiel de l'un au moins de ses points, ni de relier l'un de ses points à une masse de référence. Ce relais peut fonctionner dans un circuit d'utilisation quelconque sans qu'il y ait lieu d'introduire une alimentation particulière ou supplémentaire pour alimenter ses composants. Il peut être inséré entre deux points quelconques d'un circuit d'utilisation et peut fonctionner depuis un courant d'utilisation ayant une intensité de valeur maximum, jusqu'à un courant ayant une intensité de valeur nulle.

Sa fréquence de commutation peut être très élevée par rapport à celle d'un relais électromécanique et le courant commuté peut être un courant à haute fréquence atteignant plusieurs MHz.

L'invention a pour objet un relais autorisant ou interrompant la circulation d'un courant dans un circuit d'utilisation, comprenant un commutateur électronique statique ayant une borne reliée à une extrémité du circuit d'utilisation et une autre borne reliée à une autre extrémité de ce circuit, et un circuit de commande ayant une sortie de commande reliée à une entrée de commande du commutateur pour autoriser ou interrompre la circulation du courant dans le circuit d'utilisation et entre les deux bornes du commutateur, le circuit de commande comprenant une entrée d'alimentation et, reliés en série entre cette entrée d'alimentation et la sortie de commande, un interrupteur de commande, un générateur de courant à deux bornes et au moins une impédance limitant le courant circulant dans le circuit de commande à une valeur négligeable vis-à-vis de la valeur du courant circulant dans le circuit d'utilisation lorsque cette circulation est autorisée par la fermeture de l'interrupteur, caractérisé en ce que l'entrée d'alimentation du circuit de commande est reliée en un point quelconque du circuit d'utilisation, la tension aux bornes du générateur étant au moins égale à la plus forte différence de potentiel qui peut apparaître entre deux points quelconques du circuit d'utilisation.

Selon une autre caractéristique de l'invention, le commutateur statique est un transistor ayant une électrode de commande reliée à la sortie de commande du circuit de commande, deux autres électrodes ce ce transistor étant respectivement reliées aux deux extrémités du circuit d'utilisation, ce transistor étant bloqué lorsque ledit interrupteur de commande est ouvert et étant saturé lorsque ledit interrupteur de commande est fermé.

Selon une première variante, ledit transistor est un transistor bipolaire dont la base constitue l'électrode de commande et dont l'émetteur et le collecteur constituent les deux électrodes qui sont respectivement reliées aux deux extrémités du circuit d'utilisation.

Selon une autre caractéristique de cette variante, le commutateur comprend en outre une autre impédance reliant la base et l'émetteur du transistor bipolaire pour maintenir ce transistor à l'état bloqué lorsque l'interrupteur de commande est ouvert.

Selon une deuxième variante, ledit transistor est un transistor à effet de champ dont la grille constitue l'électrode de commande et dont la source et le drain constituent les électrodes qui sont respectivement reliées aux deux extrémités du circuit d'utilisation.

Selon une autre caractéristique de cette deuxième variante, le commutateur comprend en outre une impédance reliant la source et la grille du transistor à effet de champ pour maintenir ce transistor à l'état bloqué lorsque l'interrupteur de commande est ouvert.

Selon une autre caractéristique de la première variante, le relais comprend en outre un amplificateur de courant relié entre la sortie du circuit de commande et la base du transistor bipolaire pour produire à partir du courant fourni par le générateur de courant, lorsque l'interrupteur de commande est fermé, un courant émetteur-base du transistor bipolaire, provoquant la saturation de ce transistor.

Selon une autre caractéristique de cette même variante, l'amplificateur de courant est un amplificateur comprenant au moins un transistor, ce transistor étant polarisé par la tension disponible entre lesdites extrémités du circuit d'utilisation.

Selon une autre caractéristique de cette même variante, le générateur de courant est connecté dans le circuit de commande de manière à ne fournir aucun courant à l'amplificateur lorsque l'interrupteur de commande étant ouvert, le transistor bipolaire est bloqué.

Selon une autre caractéristique de cette même variante, une diode est reliée au collecteur du transistor bipolaire, le sens passant de cette diode étant celui du courant circulant dans le circuit émetteur-collecteur de ce transistor, les extrémités du circuit d'utilisation étant reliées respectivement à l'une des électrodes de cette diode et à l'émetteur du transistor bipolaire.

Selon une autre caractéristique, ladite impédance limitant la valeur du courant circulant dans le circuit de commande comprend une résistance de valeur élevée pour rendre négligeable ce courant vis-à-vis du courant qui circule dans le circuit d'utilisation.

Selon une autre caractéristique, ladite impédance limitant le courant comprend en outre une diode reliée en série avec la résistance de valeur élevée, le sens passant de cette diode correspondant au sens du courant dans l'électrode de commande du transistor.

Selon une autre caractéristique de la première variante, l'autre impédance reliant la base à l'émetteur du transistor bipolaire comprend une résistance de polarisation.

Selon une autre caractéristique de cette même variante, l'autre impédance reliant la base à l'émetteur du transistor bipolaire comprend en outre une diode reliée en parallèle avec la résistance de polarisation, le sens passant de cette diode étant l'inverse de celui de la jonction base-émetteur du transistor bipolaire.

Selon une autre caractéristique de la deuxième variante, l'autre impédance reliant la source à la grille du transistor à effet de champ comprend une résistance de polarisation.

Selon une autre caractéristique de cette même variante, l'autre impédance reliant la source à la grille du transistor à effet de champ comprend en outre une diode reliée en parallèle avec la résistance de polarisation, le sens passant de cette diode étant le même que celui de la jonction grille-source du transistor à effet de champ.

L'invention est aussi caractérisée en ce que dans le cas où elle s'applique à un circuit d'utilisation dans lequel circule un courant de sens quelconque ou un courant alternatif, le relais est connecté entre deux bornes d'une diagonale d'un pont redresseur à quatre diodes, deux autres bornes de l'autre diagonale de ce pont étant reliées aux deux extrémités du circuit d'utilisation.

L'invention est aussi caractérisée en ce que, dans le cas où on l'applique à un circuit d'utilisation dans lequel circule un courant de sens quelconque ou un courant alternatif, l'on connecte deux relais utilisant des transistors de types complémentaires, de préférence protégés par une diode série dans le sens passant, aux deux extrémités du circuit d'utilisation.

Selon un autre mode de réalisation, l'invention concerne aussi un relais autorisant ou interrompant la circulation d'un courant dans un circuit d'utilisation comprenant un commutateur électronique statique ayant une borne reliée à une extrémité du circuit d'utilisation et une autre borne reliée à une autre extrémité de ce circuit, et un circuit de commande ayant une sortie de commande reliée à une entrée de commande du commutateur pour autoriser ou interrompre la circulation du courant dans le circuit d'utilisation et entre les deux bornes du commutateur, caractérisé en ce que le circuit de commande comprend un amplificateur de courant polarisé par la tension disponible entre lesdites extrémités du circuit d'utilisation.

Selon une autre caractéristique de ce mode de réalisation, ledit commutateur électronique statique est un transistor bipolaire, caractérisé en ce que l'on dispose une impédance, entre lesdites bornes, reliée au circuit d'utilisation et en série sur le collecteur dudit transistor.

Selon une autre caractéristique, ladite impédance est une résistance.

Selon une autre caractéristique, ladite impédance est une diode dont le sens de conduction est le même que celui du transistor.

Les caractéristiques et avantages de l'invention ressortiront mieux de la description qui va suivre, donnée en référence aux dessins annexés, dans lesquels :

— la figure 1 représente schématiquement un relais conforme à l'invention,
— la figure 2 représente schématiquement un premier mode de réalisation d'un relais conforme à l'invention et utilisant un transistor bipolaire,
— la figure 3 représente schématiquement un autre mode de réalisation d'un relais conforme à l'invention, utilisant un transistor à effet de champ,
— la figure 4 représente de manière plus détaillée le relais de la figure 2,
— la figure 5 représente de manière plus détaillée le relais de la figure 3,
— la figure 6 représente schématiquement un autre mode de réalisation d'un relais conforme à l'invention, utilisant un transistor bipolaire et faisant intervenir un amplificateur de courant,
— les figures 7, 8 et 9 représentent des cas particuliers d'application d'un relais conforme à l'invention.

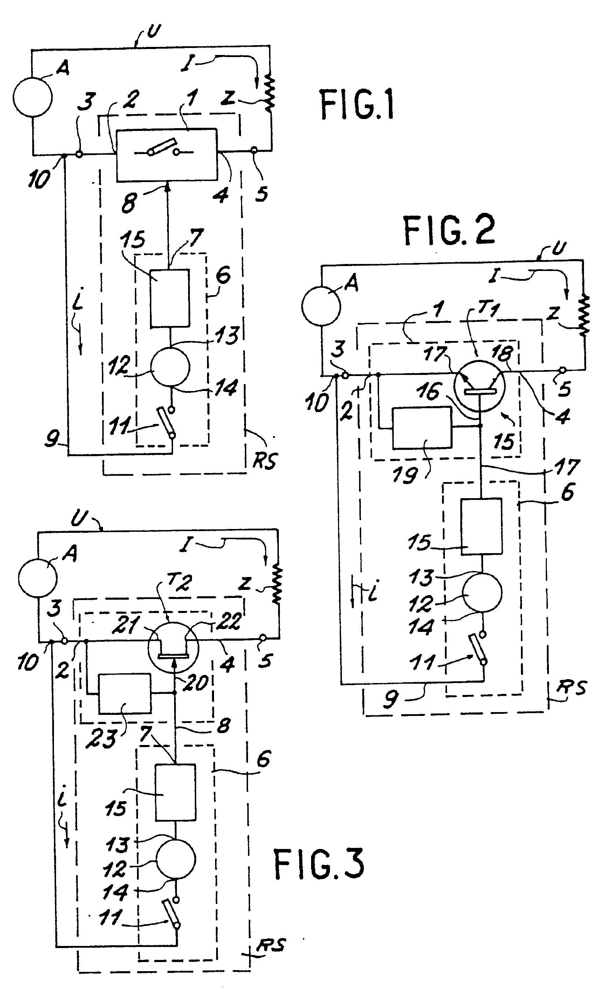

La figure 1 représente schématiquement un relais RS conforme à l'invention, qui permet d'autoriser ou d'interrompre la circulation d'un courant I dans un circuit d'utilisation U comprenant une impédance de charge Z par exemple. Ce circuit d'utilisation est alimenté par une source électrique A.

Ce relais comprend un commutateur statique 1 qui sera décrit plus loin en détail ; ce commutateur statique comprend une borne 2 qui est reliée à une extrémité 3 du circuit d'utilisation U et une autre borne 4 qui est reliée à une autre extrémité 5 de ce circuit. Ce relais comprend aussi un circuit de commande 6 ayant une sortie de commande 7 qui est reliée à une entrée de commande 8 du commutateur 1. Ce circuit de commande autorise ou interrompt la circulation du courant I dans le circuit d'utilisation et entre les deux bornes 2, 4 du commutateur 1.

Le circuit de commande 6 comprend une entrée d'alimentation 9 reliée à un point 10 du circuit d'utilisation ; ce point peut être une masse de référence si le circuit d'utilisation possède lui-même une masse de référence. Le circuit de commande comprend, reliés en série entre l'entrée d'alimentation 9 et la sortie 7 de commande, un interrupteur 11 de commande, un générateur de courant 12 à deux bornes 13, 14 et au moins une impédance 15 ; cette impédance limite le courant i circulant dans le circuit de commande lorsque l'interrupteur 11 est fermé, à une valeur négligeable vis-à-vis de la valeur du courant I circulant dans le circuit d'utilisation U ; comme on le verra plus loin en détail, la tension aux bornes 13, 14 du générateur 12 est au moins égale à la plus forte tension entre deux points quelconques du circuit d'utilisation.

Comme on le verra plus loin en détail, le commutateur statique 1 est constitué par un transistor dont une électrode de commande constitue l'entrée de commande 8 reliée à la sortie de commande 7 du circuit de commande 6 ; les deux autres électrodes de ce transistor constituent respectivement les deux bornes 2, 4 du commutateur et sont reliées aux deux extrémités 3, 5 du circuit d'utilisation U. Ce transistor est bloqué lorsque l'interrupteur de commande 11 est ouvert, tandis qu'il est saturé lorsque cet interrupteur est fermé. Les transistors utilisés sont soit de type bipolaire, soit à effet de champ.

Le relais de l'invention représenté schématiquement sur la figure 1, fonctionne de la manière suivante : si l'on désigne par I le courant circulant dans le circuit d'utilisation et par i le courant circulant dans le circuit de commande, le courant i peut être rendu négligeable en utilisant une résistance R de valeur élevée. Le générateur de courant 12 dont l'une des bornes 14 est reliée à un point 10 du circuit d'utilisation, par l'intermédiaire de l'interrupteur 11, peut être relié à une masse de référence si ce circuit d'utilisation a lui-même un point qui est relié à cette masse de référence. Si l'on désigne par $V_m$ la valeur absolue de la différence de potentiel la plus élevée que l'on peut rencontrer entre deux points quelconques du circuit d'utilisation, l'invention propose d'utiliser un générateur de courant 12 dont la force électromotrice interne $\underline{e}$ satisfait à la condition $|e| \geq V_m$. Le courant i doit simplement présenter une valeur supérieure en valeur absolue, à une valeur donnée qui correspond à la valeur du courant qui permet de faire passer le transistor du commutateur 1, de l'état bloqué à l'état saturé, lorsque l'interrupteur 11 est fermé. En ce qui concerne la force électromotrice $\underline{e}$ du générateur de courant 12, on choisit de préférence cette force électromotrice de manière que $|e| > V_m$. On peut choisir par exemple comme valeur $|e| = 2V_m$. Selon le sens du courant I dans le circuit d'utilisation, lorsque l'interrupteur 12 est fermé, la valeur du courant i est comprise entre $\dfrac{|e-V_m|}{R}$ et $\dfrac{|e+V_m|}{R}$.

Si $e = 2V_M$ la valeur du courant i dans le circuit de commande est comprise entre $\dfrac{2V_M-V_M}{R}$ et $\dfrac{2V_M+V_M}{R}$, c'est-à-dire entre $\dfrac{V_M}{R}$ et $\dfrac{3V_M}{R}$. Ce courant i qui circule dans le circuit de commande lorsque l'interrupteur 12 est fermé, doit avoir une valeur supérieure à la valeur du courant de saturation du transistor du commutateur 1.

La figure 2 représente schématiquement un premier mode de réalisation d'un relais RS conforme à l'invention, le commutateur 1 comprenant, dans ce mode de réalisation un transistor bipolaire $T_1$. Les éléments portent les mêmes références sur cette figure et sur la figure 1. Le transistor $T_1$, de type NPN par exemple comprend une base 16 qui constitue l'entrée 8 de commande du commutateur 1 ; l'émetteur 17 et le collecteur 18 de ce transistor constituent respectivement les deux bornes 2, 4 du commutateur et sont reliés aux deux extrémités 3, 5 du circuit d'utilisation. Selon une variante du mode de réalisation représenté sur cette figure, le commutateur 1 comprend en outre une autre impédance 19 reliant la base 16 et l'émetteur 17 du transistor bipolaire, pour maintenir ce transistor à l'état bloqué lorsque l'interrupteur de commande 11 est ouvert. Les impédances 15 et 19 seront décrites plus loin en détail. Il est bien évident que dans l'exemple représenté sur cette figure, et selon les sens des courants I dans le circuit d'utilisation et i dans le circuit de commande, le transistor bipolaire utilisé peut être un transistor de type PNP.

La figure 3 représente schématiquement un autre mode de réalisation d'un relais conforme à l'invention. Dans ce mode de réalisation, les mêmes éléments portent les mêmes références que sur la figure 1. Dans ce mode de réalisation, le transistor $T_2$ du commutateur 1 est un transistor à effet de champ, dont la grille 20 constitue l'électrode de commande reliée à la sortie 7 du circuit de commande. La source 21 et le drain 22 du transistor $T_2$ constituent les bornes 2, 4 du commutateur 1, qui sont respectivement reliées aux extrémités 3, 5 du circuit d'utilisation U. Selon une variante de ce mode de réalisation, le commutateur comprend en outre une impédance 23 qui relie la source 21 du transistor avec la grille 20 de celui-ci. Cette impédance permet, comme on le verra plus loin en détail, de maintenir le transistor à l'état bloqué lorsque l'interrupteur 11 est ouvert.

La figure 4 représente de manière plus détaillée, l'impédance 15 qui permet de limiter le courant dans le circuit de commande 6 lorsque l'interrupteur 11 est fermé, ainsi que l'impédance 19 qui permet de maintenir le transistor bipolaire de la figure 2 à l'état bloqué, lorsque l'interrupteur 11 est ouvert.

L'impédance 15 qui permet de limiter le courant dans le circuit de commande 6 comprend une résistance R de valeur élevée. Cette résistance peut être reliée en série avec une diode d, entre le générateur de courant 12 et la base 16 du transistor $T_1$ du commutateur 1. Cette diode évite le passage d'un courant inverse dans la jonction émetteur-base du transistor $T_1$. Le sens passant de cette diode d est le même que celui de la jonction base-émetteur du transistor $T_1$ et dépend bien entendu du type (NPN ou PNP) de ce transistor. La résistance R permet de rendre négligeable la valeur du courant i circulant dans le circuit de commande, vis-à-vis de la valeur du courant I circulant dans le circuit d'utilisation. Dans le cas où le relais doit fonctionner à des cadences de commutation élevées, la valeur de la résistance R peut introduire, avec les capacités parasites d'entrée du circuit de commande, des constantes de temps trop élevées. Dans ce cas, afin de compenser les capacités parasites d'entrée, un condensateur C est relié en parallèle avec la résistance R, de façon que la constante de temps RC soit identique à la constante de temps à neutraliser.

L'impédance 19 qui relie la base à l'émetteur du transistor $T_1$ permet de maintenir ce transistor à l'état bloqué lorsque l'interrupteur de commande 11 est ouvert. Cette impédance comprend une résistance r reliant la base 16 du transistor $T_1$, à l'émetteur 17 de ce transistor ; elle peut aussi comprendre une diode $d_1$ reliée en parallèle avec la résistance r pour protéger la jonction émetteur-base du transistor $T_1$, contre les courants inverses dans cette jonction, si aucune diode d n'a été prévue dans l'impédance 15. Le sens passant de la diode $d_1$ est bien entendu l'inverse de celui de la jonction base-émetteur du transistor $T_1$. L'impédance 19 peut être formée de la diode $d_1$ seule. Une diode supplémentaire D pourrait éventuellement être reliée entre l'émetteur et le collecteur du transistor $T_1$, pour parfaire la protection de la jonction émetteur-collecteur de ce transistor, contre les tensions inverses pouvant provenir du circuit d'utilisation.

La figure 5 représente schématiquement et de manière plus détaillée l'impédance 15 limitant le courant dans le circuit de commande du commutateur 1 comprenant un transistor $T_2$ à effet de champ comme dans le mode de réalisation de la figure 3 ; cette figure représente aussi de manière plus détaillée, l'autre impédance 23 qui relie la grille 20 du transistor $T_2$ à effet de champ, avec la source 21 de ce transistor. Les mêmes éléments portent les mêmes références sur cette figure et sur la figure 3. L'impédance 15 qui permet de limiter le courant dans le circuit de commande est constituée de la même manière que dans le cas où le commutateur 1 comprend un transistor bipolaire. La résistance R de forte valeur rend négligeable la valeur du courant dans la grille 20 du transistor $T_2$ à effet de champ. La diode d, qui peut être en série avec la résistance R, a un sens passant qui est inverse de celui de la jonction grille-source du transistor $T_2$, car ce sont les courants directs qu'il faut éviter dans cette jonction. Le condensateur C relié en parallèle avec la résistance R, intervient dans le cas où le relais est utilisé pour commuter des tensions, à des hautes fréquences.

L'impédance 23 reliée entre la grille 20 du transistor $T_2$ et la source 21 de ce transistor, comprend une résistance de polarisation r' qui permet de maintenir le transistor à effet de champ à l'état bloqué, lorsque la grille n'est pas polarisée par une tension de commande (c'est-à-dire lorsque l'interrupteur 11 est ouvert). Lorsqu'aucune diode d n'est prévue dans l'impédance 15, pour éviter les courants directs dans la jonction grille-source du transistor $T_2$, l'impédance 23 comprend une diode $d_2$ ou une diode Zener z, reliée en parallèle avec la résistance r', entre la grille 20 et la source 21 du transistor $T_2$. Ces diodes $d_2$ ou z ont un sens passant qui est le même que celui de la jonction grille-source du transistor $T_2$. Les sens de ces jonctions dépendent bien entendu du type de transistor à effet de champ utilisé (canal N ou canal P). La résistance r' ainsi que les diodes $d_2$ et z peuvent d'ailleurs être connectées à une borne d'une résistance p reliant l'impédance 15 de limitation du courant dans le circuit de commande et la grille 20 du transistor $T_2$ ; cette résistance p permet d'éviter les oscillations haute fréquence éventuelles du transistor, lorsque celui-ci doit commander des commutations à fréquence élevée. La diode Zener z permet aussi de limiter la tension de commande grille-source à une valeur déterminée.

La figure 6 représente un autre mode de réalisation d'un relais conforme à l'invention, dans le cas où le commutateur 1 comprend un transistor bipolaire $T_1$, tel que représenté sur les figures 2 ou 4. Les mêmes éléments portent les mêmes références sur la figure 6 et sur les figures 2 et 4. Dans ce mode de réalisation, le relais comprend en outre un amplificateur de courant 25 constitué par exemple par au moins un transistor, de même type que le transistor $T_1$ du commutateur 1. Cet amplificateur de courant est relié entre la sortie 7 du circuit de commande 6 et la base 16 du transistor bipolaire $T_1$. Cet amplificateur de courant est ici constitué par un transistor unique qui fournit, à partir du courant provenant du générateur de courant 12, le courant de commande base-émetteur du transistor bipolaire $T_1$, provoquant la saturation de ce transistor, lorsque l'interrupteur 11 de commande est fermé. On a également représenté sur cette figure, des résistances $r_1$, $r_2$, $r_3$ de polarisation des bases du transistor $T_1$ et du transistor de l'amplificateur 25. L'amplificateur de courant représenté sur cette figure comporte un transistor unique $T_3$ ; il est évident qu'il est possible d'utiliser un amplificateur de courant comportant plusieurs transistors (un amplificateur de type Darlington par exemple). D'autres montages amplificateurs de courant, comportant plusieurs transistors, sont connus dans l'état de la technique et ne seront pas décrits ici en détail. Le montage de l'amplificateur de courant 25 et du circuit de commande 6 est disposé de manière à ce qu'aucun courant ne traverse l'amplificateur de courant 25, lorsque l'interrupteur de commande 11 est ouvert. Le transistor bipolaire $T_1$ du commutateur 1 est, dans ce cas bloqué. Comme le montre la figure, le transistor $T_3$ de l'amplificateur 25 est polarisé par la tension disponible entre les extrémités 3, 5 du circuit d'utilisation.

Une diode Δ peut être reliée au collecteur du transistor bipolaire $T_1$ ; le sens passant de cette diode est celui du courant circulant dans le circuit collecteur-émetteur de ce transistor. Les extrémités 3, 5 du circuit d'utilisation sont reliées respectivement à l'une des électrodes de cette diode et à l'émetteur 17 du transistor bipolaire. La diode Δ permet d'obtenir une différence de potentiel suffisante pour permettre le fonctionnement correct du ou des transistors de l'amplificateur de courant 25. Cette diode peut être remplacée par une résistance λ représentée en traits interrompus sur la figure. L'amplificateur de courant 25 ne nécessite pas d'alimentation auxiliaire... Il est alimenté en dérivant le courant I circulant dans le circuit d'utilisation, de façon que la somme des courants dérivés et du courant de commande i soit égale au courant I circulant dans le circuit d'utilisation.

L'utilisation d'un amplificateur de courant pour commander le commutateur 1 permet d'obtenir la saturation du transistor de ce commutateur avec un courant i de valeur négligeable par rapport au courant I circulant dans le circuit d'utilisation.

Quelques remarques sont nécessaires sur les amplificateurs de courant permettant de commander le transistor $T_1$ du commutateur (notamment les amplificateurs de type Darlington), ainsi que sur la présence d'une diode $\Delta$ où d'une résistance $\lambda$ reliée au collecteur du transistor $T_1$, pour mieux comprendre le mode de réalisation de la figure 6.

On considère tout d'abord le cas d'un amplificateur de courant, de type Darlington le plus simple ; cet amplificateur peut être par exemple le montage de la figure 6 dans lequel les résistances $r_1$, $r_2$, $r_3$ sont supprimées. On suppose aussi que le collecteur du transistor $T_1$ est directement relié à la borne 5 du circuit d'utilisation (pas de diode $\Delta$ ou de résistance $\lambda$). Dans ce cas, lorsque le transistor $T_1$ est à l'état saturé, la chute de potentiel émetteur-collecteur de ce transistor est supérieure à celle qui apparaîtrait entre cet émetteur et ce collecteur si ce transistor n'était pas inclus dans un montage de type Darlington. Cette chute de potentiel est encore plus élevée si plusieurs étages amplificateurs de courant de type Darlington n'incluant pas de résistance sont montés en cascade. Dans ce cas en effet, les chutes de potentiel émetteur-base de chacun des transistors s'ajoutent et il apparaît, entre la base et le collecteur du transistor $T_1$ du commutateur, une tension égale à la somme des chutes de potentiel dans les transistors montés en cascade. Cette tension trop élevée empêche le transistor $T_1$ de fonctionner à son maximum de saturation.

Comme c'est à travers le transistor $T_1$ que passe justement la plus grande fraction du courant I, et que l'effet Joule dans $T_1$ est égal au produit du courant qui le traverse par la chute de tension à ses bornes, pour les valeurs élevées du courant, il en résulte dans les jonctions de $T_1$ un effet Joule considérable.

Le circuit de la figure 6 permet précisément de remédier à ces inconvénients en incluant soit une résistance $\lambda$, soit une diode $\Delta$ entre le collecteur du transistor $T_1$ et la borne 5 du circuit d'utilisation. Cette résistance de faible valeur ou cette diode provoque une faible chute de potentiel ($V_\lambda$ ou $V_\Delta$) du collecteur du transistor $T_1$, juste suffisante pour permettre à ce transistor de fonctionner dans des conditions optimales de saturation. Le transistor $T_1$ est alors polarisé par une différence de potentiel émetteur-base ($V_{E1B1}$), supérieure à la différence de potentiel émetteur-collecteur ($V_{E1C1}$), puisque :

$$V_{E1B1} = V_{E1C1} + V_\lambda (\text{ou } V_\Delta) ;$$

ce qui impose : $V_{E1B1} > V_{E1C1}$.

Il en résulte alors une meilleure saturation du transistor $T_1$ qui se traduit par une plus faible chute de potentiel $V_{E1C1}$ et donc par un plus faible effet Joule dans le transistor $T_1$. Par contre, il apparaît un effet Joule dans la résistance $\lambda$ ou la diode $\Delta$ ; mais cet effet Joule présente les particularités suivantes.

Il est facile à dissiper, car on n'est pas limité, sur une résistance, à une aussi faible élévation de température que celle qu'il ne faut pas dépasser sur une jonction semiconductrice sous peine de la détruire.

En effet, on peut admettre, pour de simples résistances, des élévations de température beaucoup plus importantes sans risquer de les endommager. Le fait de pouvoir admettre ces élévations de température améliore le facteur d'échanges thermiques avec le milieu ambiant, ce qui permet de réduire ou d'éliminer tout radiateur sur ces résistances.

D'autre part, l'expérience montre qu'il est possible de trouver une valeur optimale de la résistance $\lambda$ telle que la somme des chutes de potentiel $V_{E1C1}+V_\lambda$ soit pas supérieure, ou soit même inférieure à la seule chute de potentiel $V_{E1C1}$ dans un montage ne comportant pas la résistance $\lambda$, pour le même courant I dans le circuit d'utilisation.

L'invention permet non seulement de ne pas augmenter, mais même de diminuer l'effet Joule total, et de dissiper une partie de cet effet Joule hors du transistor $T_1$, dans la résistance $\lambda$ ; cette résistance offre, comme on vient de le voir, des possibilités de dissipation et une sécurité de fonctionnement incomparablement meilleures. La réduction de l'effet Joule dans le transistor $T_1$ permet alors de réduire proportionnellement la surface d'échanges de son radiateur.

Pour bloquer le transistor $T_1$ de façon sûre et mieux définie (insensible aux parasites), la base du transistor $T_1$ est reliée à son émetteur par une résistance $r_1$, même lorsque $T_1$ fonctionne à saturation, comme représenté sur la figure 6. Pour éviter que la résistance $r_1$ gêne la saturation de $T_1$, il suffit que cette résistance ait une valeur telle que le courant qu'elle dérive de la base du transistor $T_1$ soit faible, relativement à ce courant dans la base, lorsque $T_1$ est saturé. Les résistances $r_2$ et $r_3$ ont été décrites plus haut.

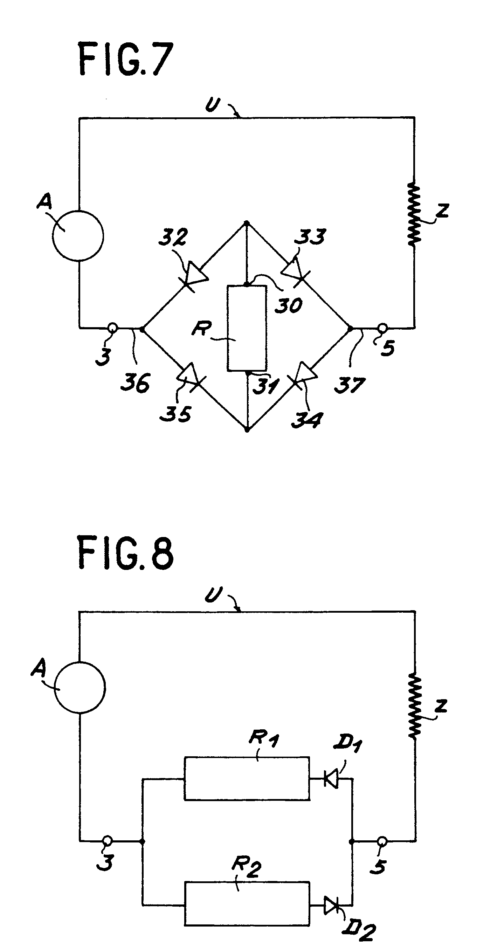

La figure 7 permet de mieux comprendre l'application d'un relais conforme à l'invention à un circuit d'utilisation U dans lequel circule un courant de sens quelconque ou un courant alternatif. On suppose que ce circuit d'utilisation est alimenté par une source de courant alternatif A et que la charge électrique de ce circuit est représentée en Z. On a également représenté sur cette figure, deux des extrémités 3, 5 du circuit d'utilisation, entre lesquelles le relais de l'invention effectue des commutations. Dans cette application, le relais qui est référencé R est connecté entre deux bornes 30, 31 d'une diagonale d'un pont redresseur à quatre diodes 32, 33, 34, 35, bien connu dans l'état de la technique. Deux autres bornes 36, 37 de l'autre diagonale du pont sont reliées aux deux extrémités 3, 5 du circuit d'utilisation U. Ainsi, le transistor du commutateur du relais ainsi que les transistors d'un éventuel amplificateur de courant de ce relais sont parcourus par des courants de même sens.

La figure 8 montre une autre application de relais conformes à l'invention, ces relais intervenant pour effectuer des commutations dans un circuit d'utilisation U comprenant une charge électrique Z dans laquelle circule un courant de sens quelconque ou un courant alternatif. Dans ce cas, deux relais $R_1$, $R_2$ conformes à l'invention, mais de polarités complémentaires et protégés par une diode redressant dans le sens passant ($D_1$, $D'_1$), sont reliés en parallèle, entre les deux extrémités 3, 5 du circuit d'utilisation U. Ces relais, qui ne sont pas représentés en détail sur la figure 8, utilisent respectivement des transistors de type complémentaire. Les interrupteurs de leurs circuits de commande respectifs peuvent être commandés parallèlement ou individuellement selon que l'on veut commuter pour n'importe quel sens du courant d'utilisation, ou pour un seul sens du courant d'utilisation.

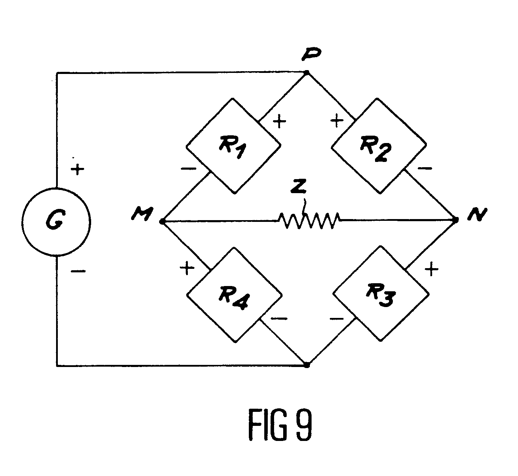

La figure 9 représente l'application à un inverseur bipolaire, de relais $R_1$, $R_2$, $R_3$, $R_4$ conformes àl'invention et représentés schématiquement par des rectangles sur la figure.

Si un courant i' circule dans les circuits de commande des commutateurs correspondant aux relais $R_1$ et $R_3$, les transistors des commutateurs correspondant (transistors $T_1$ sur les figures précédentes) sont saturés (ces transistors sont bloqués en l'absence de courant). Tout se passe alors comme si la borne M de la charge Z était reliée au pôle positif P du générateur G, et comme si la borne Z de la charge était reliée au pôle Q négatif du générateur.

Si au contraire, un courant i' circule dans les circuits de commande des commutateurs correspondant aux relais $R_2$ et $R_4$, la borne M de la charge est reliée au pôle Q négatif du générateur G, et la borne N de la charge est reliée au pôle P positif du générateur. Ce montage en pont dans lequel la charge Z occupe l'une des diagonales du pont, le générateur occupe l'autre diagonale du pont, et les relais occupent les branches de ce pont, fonctionne comme un inverseur du sens du courant dans la charge Z. Lorsqu'aucun courant i' ne circule dans les circuits de commande, la charge Z n'est pas alimentée. Le circuit inverseur est en fait un inverseur à trois états.

## Revendications

1. Relais autorisant ou interrompant la circulation d'un courant dans un circuit d'utilisation (U), comprenant un commutateur électronique statique (1) ayant une borne (2) reliée à une extrémité (3) du circuit d'utilisation et une autre borne (4) reliée à une autre extrémité (5) de ce circuit, et un circuit de commande (6) ayant une sortie de commande (7) reliée à une entrée de commande (8) du commutateur (1) pour autoriser ou interrompre la circulation du courant dans le circuit d'utilisation (U) et entre les deux bornes (2, 4) du commutateur, le circuit de commande (6) comprenant une entrée d'alimentation (9) et, reliés en série entre cette entrée d'alimentation (9) et la sortie de commande (7), un interrupteur de commande (11), un générateur de courant (12) à deux bornes (13, 14) et au moins une impédance (15) limitant le courant (i) circulant dans le circuit de commande (6) à une valeur négligeable vis-à-vis de la valeur du courant (I) circulant dans le circuit d'utilisation (U) lorsque cette circulation est autorisée par la fermeture de l'interrupteur (11), caractérisé en ce que l'entrée d'alimentation (9) du circuit de commande (6) est reliée en un point quelconque (10) du circuit d'utilisation (U), la tension aux bornes du générateur (12) étant au moins égale à la plus forte différence de potentiel qui peut apparaître entre deux points quelconques du circuit d'utilisation (U).

2. Relais selon la revendicaiton 1, caractérisé en ce que le commutateur statique est un transistor ayant une électrode de commande reliée à la sortie de commande (7) du circuit de commande, deux autres électrodes de ce transistor étant respectivement reliées aux deux extrémités (3, 5) du circuit d'utilisation (U), ce transistor étant bloqué lorsque ledit interrupteur de commande (11) est ouvert et étant saturé lorsque ledit interrupteur de commande est fermé.

3. Relais selon la revendication 2, caractérisé en ce que ledit transistor est un transistor bipolaire ($T_1$) dont la base (16) constitue l'électrode de commande et dont l'émetteur (17) et le collecteur (18) constituent les deux électrodes qui sont respectivement reliées aux deux extrémités (3, 5) du circuit d'utilisation (U).

4. Relais selon la revendication 3, caractérisé en ce que le commutateur (1) comprend une autre impédance (19) reliant la base (16) et l'émetteur (17) du transistor bipolaire ($T_1$) pour maintenir ce transistor à l'état bloqué lorsque l'interrupteur de commande (11) est ouvert.

5. Relais selon la revendication 2, caractérisé en ce que ledit transistor est un transistor à effet de champ ($T_2$) dont la grille (20) constitue l'électrode de commande et dont la source (21) et le drain (22) constituent les électrodes qui sont respectivement reliées aux deux extrémités (3, 5) du circuit d'utilisation (U).

6. Relais selon la revendication 5, caractérisé en ce que le commutateur comprend une autre impédance (23) reliant la source (21) et la grille (22) du transistor ($T_2$) à effet de champ pour maintenir ce transistor à l'état bloqué lorsque l'interrupteur de commande (11) est ouvert.

7. Relais selon la revendication 3, caractérisé en ce qu'il comprend un amplificateur de courant (25) relié entre la sortie (7) du circuit de commande (6) et la base (16) du transistor bipolaire ($T_1$) pour produire à partir du courant fourni par le générateur (12) de courant, lorsque l'interrupteur de commande (11) est fermé, un courant émetteur-base du transistor bipolaire ($T_1$), provoquant la saturation de ce transistor.

8. Relais selon la revendication 7, caractérisé en ce que l'amplificateur (25) de courant est un amplificateur comprenant au moins un transistor, ce transistor étant polarisé par la tension disponible entre lesdites extrémités (3, 5) du circuit d'utilisation.

9. Relais selon la revendication 8, caractérisé en ce que l'amplificateur de courant (25) est connecté de manière à n'être traversé par aucun courant lorsque l'interrupteur de commande (11) étant ouvert, le transistor bipolaire ($T_1$) est bloqué.

10. Relais selon la revendication 8, caractérisé en ce qu'une diode ($\Delta$) est reliée au collecteur du transistor bipolaire ($T_1$), le sens passant de cette diode étant celui du courant circulant dans la jonction émetteur-collecteur de ce transistor, les extrémités (3, 5) du circuit d'utilisation étant reliées respectivement à l'une des électrodes de cette diode ($\Delta$) et à l'émetteur (17) du transistor bipolaire ($T_1$).

11. Relais selon la revendication 2, caractérisé en ce que ladite impédance (15) limitant la valeur du courant ($i$) circulant dans le circuit de commande comprend une résistance (R) de valeur élevée pour rendre négligeable ce courant ($i$) vis-à-vis du courant (I) qui circule dans le circuit d'utilisation (U).

12. Relais selon la revendication 11, caractérisé en ce que ladite impédance (15) limitant le courant comprend une diode (d) reliée en série avec la résistance (R) de valeur élevée, le sens passant de cette diode correspondant au sens du courant dans l'électrode de commande du transistor.

13. Relais selon la revendication 4, caractérisé en ce que l'autre impédance (19) reliant la base à l'émetteur du transistor bipolaire ($T_1$) comprend une résistance (r) de polarisation.

14. Relais selon l'une au moins des revendications 4 et 13, caractérisé en ce que l'autre impédance (19) reliant la base à l'émetteur du transistor bipolaire comprend une diode ($d_1$) reliée en parallèle avec la résistance (r) de polarisation, si elle existe, le sens passant de cette diode étant l'inverse de celui de la jonction base-émetteur du transistor bipolaire ($T_1$).

15. Relais selon la revendication 6, caractérisé en ce que l'autre impédance (23) reliant la source (21) à la grille (20) du transistor à effet de champ ($T_2$) comprend une résistance de polarisation (r').

16. Relais selon la revendication 15, caractérisé en ce que l'autre impédance (23) reliant la source (21) à la grille (20) du transistor à effet de champ ($T_2$) comprend une diode ($d_2$ ou z) reliée en parallèle avec la résistance de polarisation, le sens passant de cette diode étant l'inverse de celui de la jonction grille-source du transistor ($T_2$) à effet de champ.

17. Relais autorisant ou interrompant la circulation d'un courant dans un circuit d'utilisation (U) comprenant un commutateur électronique statique (1) ayant une borne (2) reliée à une extrémité (3) du circuit d'utilisation et une autre borne (4) reliée à une autre extrémité (5) de ce circuit, et un circuit de commande (6) ayant une sortie de commande (7) reliée à une entrée de commande (8) du commutateur (1) pour autoriser ou interrompre la circulation du courant dans le circuit d'utilisation (U) et entre les deux bornes (2, 4) du commutateur, caractérisé en ce que le circuit de commande (6) comprend un amplificateur de courant (25) polarisé par la tension disponible entre lesdites extrémités (3, 5) du circuit d'utilisation.

18. Relais selon la revendication 17, dans lequel ledit commutateur électronique statique (1) est un transistor bipolaire ($T_1$), caractérisé en ce que l'on dispose une impédance, entre lesdites bornes (2) et (4), reliée au circuit d'utilisation (U) et en série sur le collecteur dudit transistor.

19. Relais selon la revendication 18, caractérisé en ce que ladite impédance est une résistance.

20. Relais selon la revendication 18, caractérisé en ce que ladite impédance est une diode ($\Delta$) dont le sens de conduction est le même que celui du transistor.

21. Application du relais conforme à l'une quelconque des revendications 1 à 20, à un circuit d'utilisation (U) dans lequel circule un courant de sens quelconque ou un courant alternatif, caractérisé en ce que le relais est connecté entre deux bornes (30, 31) d'une diagonale d'un pont redresseur à quatre diodes (32, 33, 34, 35), deux autres bornes (36, 37) de l'autre diagonale de ce pont étant reliées aux deux extrémités (3, 5) du circuit d'utilisation (U).

22. Application du relais conforme à l'une quelconque des revendications 1 à 20, à un circuit d'utilisation (U) dans lequel circule un courant de sens quelconque où un courant alternatif, caractérisé en ce que l'on connecte deux relais ($R_1$, $R_2$) utilisant des transistors de types complémentaires, aux deux extrémités (3, 5) du circuit d'utilisation, les interrupteurs de commande respectifs de ces deux relais étant commandés parallèlement ou individuellement selon que l'on veut commuter pour n'importe quel sens du courant d'utilisation, ou pour un seul sens du courant d'utilisation.

23. Application du relais à inverseur bipolaire de courant dans une charge, cet inverseur comprenant quatre relais conformes à l'une quelconque des revendications 1 à 20, disposés respectivement dans quatre branches d'un pont, la charge étant située dans une diagonale du pont et un générateur étant situé dans une autre diagonale du pont.

**Ansprüche**

1. Relais zum Ermöglichen oder Unterbrechen eines Stromflusses in einer Anwenderschaltung (U) mit einem statischen, elektronischen Schalter (1) mit einer Klemme (2), die mit einem Ende (3) des Anwenderschaltkreises verbunden ist, und einer weiteren Klemme (4), die mit einem weiteren Ende (5) dieses Schaltkreises verbunden ist, und einem Steuerungsschaltkreis (6) mit einem Steuerungsausgang (7), der mit einem Steuerungseingang (8) des Schalters (1) verbunden ist, um den Stromfluß im Anwenderschaltkreis (U) und zwischen den beiden Schalterklemmen (2, 4) zu ermöglichen oder zu unterbrechen, wobei der Steuerungsschaltkreis (6) einen Versorgungseingang (9) und, in Reihe zwischen diesem Versorgungseingang (9) und dem Steuerungsausgang (7) angeschlossen, einen Steuerungsschalter (11) umfaßt, wobei ein Stromgenerator (12) mit zwei Anschlüssen (13, 14) und wenigstens einer Impedanz (15) den in dem Steuerungsschaltkreis (6) fließenden Strom (i) auf einen im Vergleich mit dem Wert des in dem Anwenderschaltkreis (U) fließenden Stroms (I), wenn der Stromfluß durch das Schließen des Schalters (22) ermöglicht ist, vernachlässigbaren Wert begrenzt, dadurch gekennzeichnet, daß der Versorgungseingang (9) des Steuerungsschaltkreises (6) an irgendeinem Punkt (10) mit dem Anwenderschaltkreis (U) verbunden ist, wobei dieSpannung an den Klemmen des Generators (12) wenigsten gleich der höchsten Potentialdifferenz ist, die zwischen zwei beliebigen Punkten des Anwender-schaltkreises (U) auftreten kann.

2. Relais nach Anspruch 1, dadurch gekennzeichnet, daß der statische Schalter ein Transistor ist, der eine Steuerungselektrode besitzt, die mit dem Steuerungsausgang (7) des Steuerungsschaltkreises verbunden ist, wobei die beiden anderen Elektroden dieses Transistors,jeweils mit den beiden Enden (3, 5) des Anwenderschaltkreises (U), verbunden sind, wobei dieser Transistor gesperrt ist, wenn der Steuerungsschalter (11) geöffnet ist, und gesättigt ist, wenn der Steuerungsschalter geschlossen ist.

3. Relais nach Anspruch 2, dadurch gekennzeichnet, daß der Transistor ein Bipolartransistor (T₁) ist, dessen Basis (16) die Steuerungselektrode bildet und dessen Emitter (17) um Kollektor (18) die beiden anderen Elektroden bilden, die jeweils mit den beiden Enden (3, 5) des Anwenderschaltkreises (U) verbunden sind.

4. Relais nach Anspruch 3, dadurch gekennzeichnet, daß der Schalter (1) eine weitere Impedanz (19) aufweist, die die Basis (16) und den Emitter (17) des Bipolartransistors (T₁) miteinander verbindet, um diesen Transistor im gesperrten Zustand zu halten, wenn der Steuerungsschalter (11) geöffnet ist.

5. Relais nach Anspruch 2, dadurch gekennzeichnet, daß der Transistor ein Feldeffekttransistor (T₂) ist, dessen Gate (20)die Steuerungs-elektrode bildet und dessen Source (21) und Drain (22) die Elektroden bilden, die jeweils mit den beiden Enden (3, 5) des Anwenderschaftkreises (U) verbunden sind.

6. Relais nach Anspruch 5, dadurch gekennzeichnet, daß der Schalter eine weitere Impedanz (23) aufweist, die die Source (21) und das Gate (22) des Transistors (T₂) miteinander verbindet, um diesen Transistor im gesperrten Zustand zu halten, wenn der Steuerungsschalter (11) geöffnet ist.

7. Relais nach Anspruch 3, dadurch gekennzeichnet, daß es einen Stromverstärker (25) umfaßt, der zwischen dem Ausgang (7) des Steuerungsschaltkreises (6) und der Basis (16) des Bipolartransistors (T₁) angeschlossen ist, um ausgehend vom von dem Stromgenerator (12) erzeugten Strom einen Emitter-Basis-Strom des Bipolartransistors (T₁) zu erzeugen, wenn der Steuerungsschalter (11) geschlossen ist, wodurch die Sättigung dieses Transistors bewirkt wird.

8. Relais nach Anspruch 7, dadurch gekennzeichnet, daß der Strom-verstärker (25) ein Verstärker mit wenigstens,einem Transistor ist, wobei dieser Transistor durch die zwischen den Enden (3, 5) des Anwenderschaltkreises verfügbare Spannung polarisiert ist.

9. Relais nach Anspruch 8, dadurch gekennzeichnet, daß der Stromverstärker (25) so angeschlossen ist, daß er von keinem Strom durchflossen wird, wenn der bei Öffnung des Steuerungsschalters (11) der Bipolartransistor (T₁) gesperrt ist.

10. Relais nach Anspruch 8, dadurch gekennzeichnet, daß einen Diode (Δ) mit dem Kollektor des Bipolartransistors (T₁) verbunden ist,wobei die Durchlaßrichtung dieser Diode die des im Emitter-Kollektor-Übergang dieses Transistors fließenden Stroms ist, wobei die Enden (3, 5) des Benutzerschaltkreises jeweils mit einer des Elektroden dieser Diode (Δ) und mit dem Emitter (17) des Bipolartransistors (T₁) verbunden sind.

11. Relais nach Anspruch 2, dadurch gekennzeichnet, daß die Impedanz (15), die den Wert des in dem Steuerungsschaltkreis fließenden Stroms (i) begrenzt, einen Widerstand (R) mit hohem Wert umfaßt, um diesen Strom (i) im Vergleich mit dem Strom (I), der in dem Anwenderschaltkreis (U) fließt, vernachlässigbar zu machen.

12. Relais nach Anspruch 11, dadurch gekennzeichnet, daß die den Strom begrenzende Impedanz (15) eine Diode (d) umfaßt, die in Reihe mit dem Widerstand (R) mit hohem Wert geschaltet ist, wobei die Durchlaßrichtung dieser Diode der Stromrichtung in der Steuerelektrode des Transistors entspricht.

13. Relais nach Anspruch 4, dadurch gekennzeichnet, daß die andere Impedanz (19), die die Basis mit dem Emitter des Bipolartransistors (T₁) verbindet, einen Polarisationswiderstand (r) umfaßt.

14. Relais nach wenigstens einem der Ansprüche 4 und 13, dadurch gekennzeichnet, daß die andere Impedanz (19), die die Basis mit dem Emitter des Bipolartransistors (T₁) verbindet, einen Diode (d₁) umfaßt, die parallel mit dem Polarisationswiderstand (r) verbunden ist, wenn dieser vorhanden ist, wobei die Durchlaßrichtung dieser Diode umgekehrt zu der des Basis-Emitter-Übergangs des Bipolartransistors (T₁) ist.

15. Relais nach Anspruch 6, dadurch gekennzeichnet, daß die andere Impedanz (23), die die Source (21) mit dem Gate (20) des Feldeffektransistors (T₂) verbindet, einen polarisationswiderstand (r') umfaßt.

16. Relais nach Anspruch 15, dadurch gekennzeichnet ; daß die andere Impedanz (23), die die Source (21) mit dem Gate (20) des Feldeffekttransistors (T2) verbindet, eine Diode (d₂ oder z) umfaßt, die parallel mit dem Polarisationswiderstand verbunden ist, wobei die Durchlaßrichtung dieser Diode umgekehrt zu der des Gate-Source-Übergangs des Feldeffekttransistors (T₂) ist.

17. Relais zum Ermöglichen oder Unterbrechen eines Stromflusses in einer Anwenderschaltung (U), mit einem statischen, elektronischen Schalter (1) mit einer Klemme (2), die mit einem Ende (3) des Anwenderschaltkreises verbunden ist, und einer weiteren Klemme (4), die mit einem weiteren Ende (5) dieses Schaltkreises verbunden ist, und einem Steuerungsschaltkreis (6) mit einem Steuerungsausgang (7), der mit einem Steuerungseingang (8) des Schalters (1) verbunden ist, um den -Stromfluß im Anwenderschaltkreis (U) und zwischen den beiden Schalterklemmen (2, 4) zu ermöglichen oder zu unterbrechen, dadurch gekennzeichnet, daß der Steuerungsschaltkreis (6) einen durch die zwischen den Enden (3, 5) des Anwenderschaltkreises verfügbare Spannung polarisierten Verstärker (25) umfaßt.

18. Relais nach Anspruch 17, bei dem der statische, elektronische Schalter (1) ein Bipolartransistor (T₁) ist, dadurch gekennzeichnet, daß man eine Impedanz zwischen die Klemmen (2) und (4) anordnet, die mit dem Anwenderschaltkreis (U) verbunden und in Reihe mit dem Kollektor des Transistors ist.

19. Relais nach Anspruch 18, dadurch gekennzeichnet, daß die Impedanz ein Widerstand ist.

20. Relais nach Anspruch 18, dadurch gekennzeichnet, daß die Impedanz einen Diode (Δ) ist, deren Durchlaßrichtung dieselbe wie die des Transistors ist.

21. Anwendung des Relais nach einem der Ansprüche 1 bis 20 in einem Anwenderschaltkreis (U) in dem ein Strom in beliebiger Richtung oder ein Wechselstrom fließt, dadurch gekennzeichnet, daß das Relais zwischen zwei Klemmen (30, 31) einer Diagonalen einer Gleichrichterbrücke aus vier Dioden (32, 33, 34, 35) angeordnet ist, wobei zwei weitere Klemmen (36, 37) der anderen Diagonalen dieser Brücke mit den beiden Enden (3, 5) des Anwenderschaltkreises (U) verbunden sind.

22. Anwendung des Relais nach einem der Ansprüche 1 bis 20 in einem Anwenderschaltkreis (U) in dem ein Strom in beliebiger Richtung oder ein Wechselstrom fließt, dadurch gekennzeichnet, daß man zwei Relais (R₁, R₂), die Transistoren komplementären Typs verwenden, mit den Enden (3, 5) des Anwenderschaltkreises verbindet, wobei die jeweiligen Steuerungsschalter dieser beiden Relais parallel oder individuell gesteuert werden, je nachdem, ob man für irgendeine Richtung des Anwenderstroms oder für eine einzige Richtung des Anwenderstroms schalten möchte.

23. Anwendung des Relais mit bipolarem Strominverter in einer Last, wobei dieser Inverter vier Relais nach einem der Ansprüche 1 bis 20 umfaßt, die jeweils In vier Zweigen einer Brücke angeordnet sind, wobei die Last in einer Diagonalen der Brücke angeordnet ist und ein Generator in einer anderen Diagonalen der Brücke angeordnet ist.

## Claims

1. Relay authorizing or interrupting the flow of a current in a load circuit (U), comprising a static electronic switch (1) having one terminal (2) connected to one end (3) of the load circuit and another terminal (4) connected to another end (5) of said circuit, and a control circuit (6) having a control output (7) connected to a control input (8) of the switch (1) to authorize or interrupt the flow of current in the load circuit (U) and between the two switch terminals (2, 4), the control circuit (6) comprising a supply input (9) and, connected in series between said input (9) and the control output (7), a control switch (11), a current generator (12) with two terminals (13, 14) and at least one impedance (15) limiting the current (i) flowing in the control circuit (6) to a negligible value compared with the value of the current (i) flowing in the load circuit (U) when said flow is authorized by the closing of the switch (11), characterized in that the supply input (9) of the control circuit (6) is connected at a random point (10) of the load circuit (U), the voltage at the generator terminals (12) being at least equal to the greatest potential difference which can appear between two random points of the load circuit (U).

2. Relay according to claim 1, characterized in that the static switch is a transistor having a control electrode connected to the control output (7) of the control circuit, two other electrodes of said transistor being respectively connected to the two ends (3, 5) of the load circuit (U), said transistor being blocked when said control switch (11) is open and being saturated when said control switch is closed.

3. Relay according to claim 2, characterized in that the transistor is a bipolar transistor (T₁), whose base (16) constitutes the control electrode and whose emitter (17) and collector (18) constitute the two electrodes respectively connected to the two ends (3, 5) of the load circuit (U).

4. Relay according to claim 3, characterized in that the switch (1) comprises another impedance (19) connecting the base (16) and emitter (17) of the bipolar transistor (T₁), so as to maintain said transistor in the off state when the control switch (11) is open.

5. Relay according to claim 2, characterized in that said transistor is a field effect transistor (T₂), whose gate (20) constitutes the control electrode and whose source (21) and drain (22) constitute the electrodes respectively connected to the two ends (3, 5) of the load circuit (U).

6. Relay according to claim 5, characterized in that the switch comprises another impedance (23) connecting the source (21) and gate (22) of the field effect transistor ($T_2$) to keep said transistor in the off state when the control switch (11) is open.

7. Relay according to claim 3, characterized in that it comprises a current amplifier (25) connected between the output (7) of the control circuit (6) and the base (16) of the bipolar transistor ($T_1$) to produce an emitter-base current of the bipolar transistor ($T_1$) bringing about the saturation of the latter from the current supplied by the current generator (12), when the control switch (11) is closed.

8. Relay according to claim 7, characterized in that the current amplifier (25) is an amplifier comprising at least one transistor, the latter being polarized by the voltage available between said ends (3, 5) of the load circuit.

9. Relay according to claim 8, characterized in that the current amplifier (25) is connected in such a way as not to be traversed by any current when the control switch (11) is open and the bipolar transistor ($T_1$) blocked.

10. Relay according to claim 8, characterized in that a diode (Δ) is connected to the collector of the bipolar transistor ($T_1$), the conducting direction of said diode being that of the current flowing in the emitter-collector junction of the transistor, the ends (3, 5) of the load circuit being respectively connected to one of the electrodes of said diode (Δ) and to the emitter (17) of the bipolar transistor ($T_1$).

11. Relay according to claim 2, characterized in that the impedance (15) limiting the value of the current (i) flowing in the control circuit comprises a high value resistor (R) to render negligible the said current (i) compared with that current (I) flowing in the load circuit (U).

12. Relay according to claim 11, characterized in that the impedance (15) limiting the current comprises a diode (d) connected in series with the high value resistor (R), the conducting direction of said diode corresponding to the direction of the current in the control electrode of the transistor.

13. Relay according to claim 4, characterized in that the other impedance (19) connecting the base to the emitter of the bipolar transistor ($T_1$) comprises a polarization resistor (r).

14. Relay according to at least one of the claims 4 and 13, characterized in that the other impedance (19) connecting the base to the emitter of the bipolar transistor comprises a diode ($d_1$) connected in parallel with the polarization resistor (r), if one is provided, the conducting direction of said diode being the reverse of that of the base-emitter junction of the bipolar transistor ($T_1$).

15. Relay according to claim 6, characterized in that the other impedance (23) connecting the source (21) to the gate (20) of the field effect transistor ($T_2$) comprises a polarization resistor (r').

16. Relay according to claim 15, characterized in that the other impedance (23) connecting the source (21) to the gate (20) of the field effect transistor ($T_2$) comprises a diode ($d_2$ or z) connected in parallel with the polarization resistor, the conducting direction of said diode being the reverse of that of the gate-source junction of the field effect transistor ($T_2$).

17. Relay authorizing or interrupting the flow of a current in a load circuit (U) comprising a static electronic switch (1) having a terminal (2) connected to one end (3) of the load circuit and another terminal (4) connected to another end (5) of said circuit, and a control circuit (6) having a control output (7) connected to a control input (8) of the switch (1) for authorizing or interrupting the flow of current in the load circuit (U), and between the two terminals (2, 4) of the switch, characterized in that the control circuit (6) comprises a current amplifier (25) polarized by the voltage available between said two ends (3, 5) of the load circuit.

18. Relay according to claim 17, in which the static electronic switch (1) is a bipolar transistor ($T_1$), characterized in that an impedance is positioned between said terminals (2, 4), connected to the load circuit (U) and in series with the collector of said transistor.

19. Relay according to claim 18, characterized in that said impedance is a resistor.

20. Relay according to claim 18, characterized in that said impedance is a diode (Δ), whose conducting direction is the same as that of the transistor.

21. Application of the relay according to any one of the claims 1 to 20 to a load circuit (U) in which flows a current having a random direction or an alternating current, characterized in that the relay is connected between two terminals (30, 31) of a diagonal of a four-diode rectifier bridge (32, 33, 34, 35), two other terminals (36, 37) of the other bridge diagonal being connected to the two ends (3, 5) of the load circuit (U).

22. Application of the relay according to any one of the claims 1 to 20 to a load circuit (U) in which flows a current with a random direction or an alternating current, characterized in that two relays ($R_1$, $R_2$) using transistors of complementary types are connected to the two ends (3, 5) of the load circuit, the respective control switches of said two relays being controlled in parallel or individually, as a function of whether it is wished to switch for any random load current direction, or for a single load current direction.

23. Application of the relay to a bipolar current inverter in a load, said inverter comprising four relays according to any one of the claims 1 to 20, arranged respectively in the four branches of a bridge, the load being located in one diagonal of the bridge and a generator being located in the other diagonal of the bridge.

FIG.1

FIG.2

FIG.3

FIG.4

FIG.5

FIG.6

# FIG.7

# FIG.8

FIG 9